(19) Europäisches Patentamt
European Patent Office
Office européen des brevets

(11) **EP 2 145 208 B1**

(12) **FASCICULE DE BREVET EUROPEEN**

(45) Date de publication et mention
de la délivrance du brevet:
**08.10.2014 Bulletin 2014/41**

(51) Int Cl.:
**G01T 1/24** (2006.01)    **H01L 27/146** (2006.01)
**G01T 1/29** (2006.01)

(21) Numéro de dépôt: **08805756.7**

(22) Date de dépôt: **07.05.2008**

(86) Numéro de dépôt international:
**PCT/FR2008/050807**

(87) Numéro de publication internationale:
**WO 2008/149003 (11.12.2008 Gazette 2008/50)**

(54) **DISPOSITIF D'IMAGERIE PAR RAYONS X À SOURCE POLY-CHROMATIQUE**

RÖNTGENABBILDUNGSVORRICHTUNG MIT EINER POLYCHROMATISCHEN QUELLE

X-RAY IMAGING DEVICE HAVING A POLYCHROMATIC SOURCE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **10.05.2007 FR 0754974**

(43) Date de publication de la demande:
**20.01.2010 Bulletin 2010/03**

(73) Titulaires:
• **Centre National de la Recherche Scientifique (CNRS)**
**75016 Paris (FR)**
• **Université d'Aix-Marseille**
**13284 Marseille Cedex 07 (FR)**

(72) Inventeurs:
• **MOREL, Christian**
**F-13008 Marseille (FR)**
• **DEBARBIEUX, Franck**
**F-13008 Marseille (FR)**
• **DELPIERRE, Pierre**
**F-13600 La Ciotat (FR)**
• **MEESSEN, Christophe**
**F-13008 Marseille (FR)**

(74) Mandataire: **Domenego, Bertrand**
**Cabinet Lavoix**
**2, place d'Estienne d'Orves**
**75441 Paris Cedex 09 (FR)**

(56) Documents cités:
EP-A2- 0 854 639    GB-A- 2 318 411
US-A- 3 376 420    US-A- 5 635 718

• LUNDGREN ET AL: "An area efficient readout architecture for photon counting color imaging" NUCLEAR INSTRUMENTS & METHODS IN PHYSICS RESEARCH, SECTION - A: ACCELERATORS, SPECTROMETERS, DETECTORS AND ASSOCIATED EQUIPMENT, ELSEVIER, AMSTERDAM, NL, vol. 576, no. 1, 6 février 2007 (2007-02-06) , pages 132-136, XP022072098 ISSN: 0168-9002

EP 2 145 208 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention concerne un dispositif d'imagerie par rayons X à source poly-chromatique, et plus particulièrement un tel dispositif comprenant un détecteur à pixels adaptés à fonctionner en mode comptage de photons dans une fenêtre d'énergie délimitée par au moins un seuil réglable, de sorte que chaque pixel fournit une sortie fonction du nombre de photons reçus par ledit pixel dans ladite fenêtre d'énergie pendant un intervalle de temps prédéterminé, et des moyens de réglage aptes à régler les seuils desdits pixels.

De tels détecteurs sont décrits dans les documents "XPAD: A photons counting pixel detector for material sciences and small animal imaging", P. Delpierre et al., Nucl. Instr. Meth. in Physics Research A 572 (2007) 250-253 ; "XPAD3: A new photon counting chip for X-ray CT-scanner", P. Pangaud et al., Nucl. Instr. Meth. in Physics Research A 571 (2007) 321-324 ; "PIXSCAN: Pixel detector CT-scanner for small animal imaging", P. Delpierre et al., Nucl. Instr. Meth. in Physics Research A 571 (2007) 425-428.

Il est très souvent nécessaire de connaître la composition chimique d'un matériau ou encore de localiser la présence d'un élément chimique dans un corps opaque à la lumière visible. Ceci est vrai aussi bien pour trier des objets inconnus que pour localiser la présence d'un marqueur médical (p. ex. un agent de contraste) dans un être vivant.

Pour cela, il est possible d'optimiser le spectre d'émission d'une source de rayons X poly-chromatique afin de maximiser la contribution des longueurs d'ondes fortement absorbées par l'élément à détecter (ceci augmente le contraste utile) et de limiter la contribution des longueurs d'ondes qui sont absorbées préférentiellement par les autres atomes de l'environnement (dans le but de réduire le contraste induit par le fond). De cette façon, les régions à forte teneur en élément d'intérêt se découpent sur le fond.

Dans cette perspective, des sources pseudo monochromatiques ont été développées en tirant profit des pics de réarrangement intenses émis aux énergies caractéristiques du substrat d'une anti-cathode. Néanmoins, il reste une forte contribution des nombreuses autres longueurs d'ondes capables d'induire un contraste polluant qui noie l'information recherchée pour un objet complexe. De plus, le spectre idéal dépend aussi bien de la nature de l'atome recherché que de l'environnement dans lequel on souhaite le détecter. Aussi en pratique l'utilisateur est-il systématiquement confronté à la difficulté de trouver une source poly-chromatique générant un contraste optimal dans toutes les conditions d'utilisation. Si on se place dans le contexte particulier de l'imagerie médicale, une source donnée n'est adaptée que pour un seul type d'agent de contraste (p. ex. l'iode, mais pas le baryum ou le gadolinium), et pour une région du corps de densité moyenne donnée (p. ex. le sein ou la main).

Pour réduire la dépendance vis-à-vis de l'environnement chimique, une méthode consiste à utiliser deux sources poly-chromatiques de spectres différents, dont l'une maximise les énergies préférentiellement absorbées par l'agent de contraste (i.e. une source pseudo monochromatique avec forte densité de photons au voisinage de la transition photoélectrique K de l'agent de contraste) et l'autre pas (idéalement une source de spectre uniforme). En faisant le rapport des atténuations obtenues à partir de chacune des deux sources, on fait alors ressortir sur l'image les régions qui contiennent l'élément recherché, car elles seules ont une atténuation très différente sous ces deux conditions.

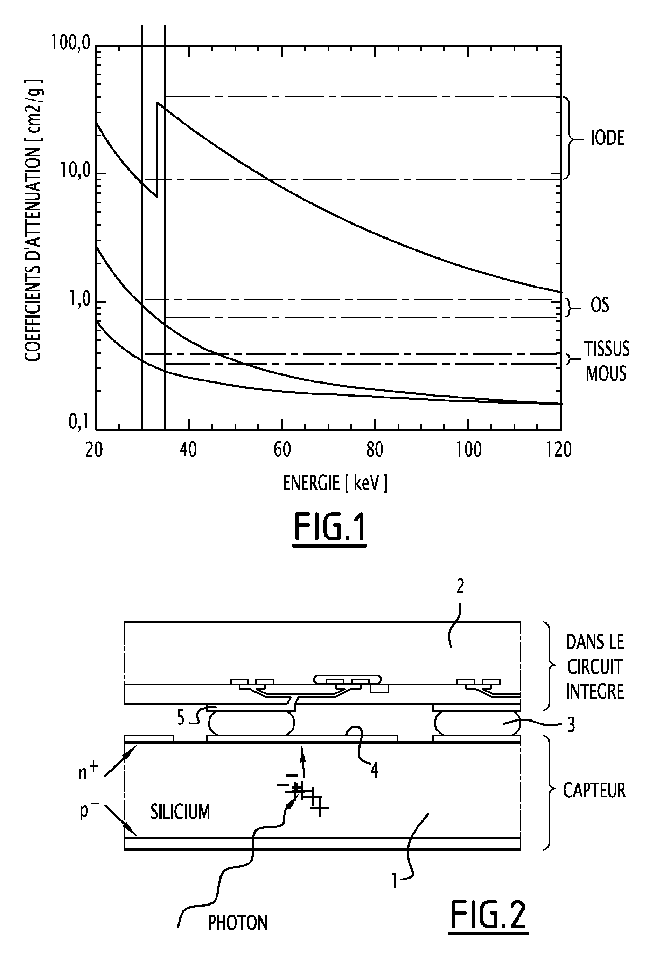

Une solution beaucoup plus raffinée utilise les faisceaux monochromatiques disponibles sur synchrotron, car ils sont accordables à deux longueurs d'ondes précises, juste au-dessous et au-dessus de la transition K de l'élément recherché. L'avantage est que l'absorption par l'environnement ne varie quasiment pas entre les deux conditions d'irradiation alors que l'élément d'intérêt montre un changement brutal et très prononcé de son absorption (changement d'absorption par un facteur 10 pour un composé pur). La figure 1 illustre cette méthode dans le cas de l'iode. Dans ce cas, le contraste n'est plus pollué par les gradients d'absorption de l'environnement puisque celui-ci garde une absorption quasi constante pour les deux longueurs d'ondes voisines. Il s'ensuit une amélioration considérable de la sensibilité de détection de l'élément comme indiqué dans la littérature.

En outre, parce que les faisceaux sont monochromatiques, il est possible de définir un coefficient d'atténuation absolu pour une énergie donnée. Ce coefficient d'atténuation s'obtient à partir du rapport des statistiques de photons incidents et détectés au travers de l'objet dont on calcule le logarithme. Si on soustrait deux tels coefficients d'atténuation pour deux énergies données, on obtient un coefficient d'atténuation relatif qui est proportionnel à la concentration de l'élément dont la transition électronique se situe entre ces deux énergies pour une épaisseur de matière donnée. Par comparaison à une courbe tabulée, il est possible d'avoir une mesure quantitative de la concentration de l'élément à partir du coefficient d'atténuation relatif. En imagerie médicale, cette méthode permet de détecter des concentrations d'iode aussi faibles que 15 à 50 $\mu$g/ml, et donc de mettre en évidence et de localiser des tumeurs qui sont invisibles par les techniques classiques (i.e. avec des sources poly-chromatiques).

Cette technique a donc fait ses preuves, mais elle demande d'une part l'accès à une ligne de faisceau synchrotron et nécessite d'autre part d'acquérir les données de façon séquentielle, longueur d'onde après longueur d'onde. Or l'acquisition séquentielle devient fastidieuse et longue si on est intéressé par la détection de plusieurs éléments chimiques dans le même corps.

Une façon de palier à ce problème est de travailler sur la partie "détecteur" plutôt que sur la source pour réaliser des images longueur d'onde par longueur d'onde. Les détecteurs à pixels hybrides sont particulièrement dédiés à cet usage dans la mesure où ils permettent de s'affranchir des inconvénients liés à l'utilisation des sources synchrotrons.

Le document DE 199 04 904 décrit l'utilisation de pixels hybrides simple seuil et double seuils pour l'imagerie de contraste, mais ne décrit pas de moyen permettant d'obtenir une magnification en temps réel.

Le document US 2005/0123093 décrit d'une manière générale le principe de la magnification de contraste.

Plus particulièrement, les documents US 2006/0056581 et US 6 922 462 décrivent une méthode de magnification temps réel utilisant un détecteur multicouche.

Toutefois, les circuits électroniques associés à chacun des éléments de détection pour le comptage des photons dans une fenêtre en énergie donnée sont compliqués (plusieurs millions de transistors) et une importante difficulté est de les contenir dans une surface égale ou inférieure à la surface de l'élément de détection. Par conséquent, inclure dans chacun de ces circuits plusieurs fenêtres en énergie, avec les compteurs de photons et les moyens de réglage et de lecture correspondants, a pour conséquence une augmentation de surface du pixel et donc une détérioration de la résolution spatiale.

On peut palier partiellement à ce problème en utilisant des technologies submicroniques, mais les masques et la fonderie de production de ces circuits deviennent extrêmement coûteux. Même en utilisant une technologie de 0,25 $\mu$m on ne peut pas descendre la taille du pixel en dessous de 50 $\mu$m pour seulement une fenêtre en énergie. Cette dimension est pratiquement proportionnelle au nombre de fenêtres.

Une solution dont de pouvoir faire plusieurs fenêtres en énergie tout en gardant un circuit simple à un seul seuil. On peut ce résultat en organisant les pixels par groupes de pixels (par exemple 4 pixels) et en attribuant une fenêtre en énergie différente pour chacun des pixels de ce groupe (pixels composites). L'inconvénient est que la résolution spatiale et spectrale correspond alors à la dimension du groupe de pixels et se trouve ainsi détériorée.

Un moyen d'améliorer les performances est décrit dans la publication Lungren et al., "An area efficient readout architecture for photon counting color imaging", Nuclear Instruments and Methods in Physics Research, Section A, Accelerators, spectrometers, detectors, Elsevier, Amsterdam NL ,vol. 576, no .1 ,6 février 2007, pages 132-136, XP022072098, ISSN 0168-9002. La méthode décrite dans se document consiste à doter chacun des pixels d'un seul seuil en énergie mais d'ajouter deux fenêtres en énergie par ensemble de quatre pixels. On donne alors à chaque pixel une pondération en énergie calculée par l'intensité de photons reçue par chaque pixel et le nombre de photons en sortie de la fenêtre d'énergie correspondante du groupe de quatre pixels. On obtient ainsi deux fenêtres en énergie, une troisième fenêtre est déduite de la différence entre l'intensité totale et la somme des sorties des deux premières fenêtres. La résolution spatiale en intensité correspond à la taille d'un pixel, par contre la résolution en énergie correspond à la taille du groupe de quatre pixels et il est nécessaire d'agrandir la taille des pixels pour incorporer le circuit qui fournit les deux fenêtres en énergie.

Comme il est décrit dans cet article, cette méthode correspond à un progrès par rapport à celle qui consiste à doter chacun des pixels d'un groupe de quatre d'une fenêtre différente en énergie. Cependant, elle exige d'augmenter la taille des pixels de sorte que la résolution de la fenêtre d'énergie correspond à la taille d'un groupe de quatre pixels, c'est-à-dire est détériorée d'un facteur 4.

GB 2 318 411 décrit un dispositif d'imagerie par radiations dans lequel seules les radiations incidentes dans une ou des gammes d'énergies (s) donnée (s) sont comptées.

US 3 376 420 décrit un système de spectrométrie par activation de neutrons.

La presente invention vise à palier les inconvénients de l'art antérieur.

Plus particulièrement, l'invention a pour but de fournir un dispositif d'imagerie permettant la magnification en temps réel de plusieurs agents de contraste avec une seule source.

L'invention a également pour but d'utiliser une même source pour la recherche de différents éléments chimiques.

A cet effet, l'invention a pour objet un dispositif d'imagerie par rayons X, comprenant une source polychromatique (10) de rayons X, et un détecteur (1, 2) à pixels adaptés à fonctionner en mode de comptage de photons dans au moins une fenêtre d'énergie délimitée par au moins un seuil réglable, au moins un compteur, de sorte que chaque pixel fournit une sortie fonction du nombre de photons reçus par ledit pixel dans lesdites fenêtres d'énergie pendant un intervalle de temps prédéterminé, des moyens de réglage (12) aptes à régler en temps réel les seuils desdits pixels successivement dans différentes fenêtres d'énergie et des moyens de traitement (16) pour effectuer en temps réel un traitement différentiel des sorties desdits pixels dans lesdites différentes fenêtres d'énergie. Les moyens de réglage sont agencés pour régler les seuils desdits pixels en temps réel à différentes valeurs selon une répartition temporelle cyclique, et les moyens de traitement sont agencées pour traiter selon un agencement temporel les sorties desdits pixels.

L'invention permet donc de réaliser une mesure spectrale dans un nombre bien supérieur de fenêtres en énergie (limité uniquement par la vitesse d'horloge des processeurs et la puissance de la source) tout en pouvant conserver un circuit électronique simple par pixel, ce qui est bénéfique pour réduire la taille des pixels, et donc améliorer la résolution spatiale. On maximise donc la résolution spatiale simultanément en intensité et pour la sélection d'énergie (résolution correspondant à la taille d'un pixel).

Un autre avantage essentiel de l'invention est donc sa polyvalence puisqu'elle peut être adaptée de façon logicielle aux besoins expérimentaux spécifiques de l'utilisateur.

On observera que le détecteur précité peut notamment être bidimensionnel. Il peut s'agir en particulier d'un détecteur à pixels hybrides.

Dans un mode de réalisation particulier, lesdits pixels sont des pixels élémentaires groupés en pixels composites selon une répartition géométrique prédéterminée, et les moyens de réglage sont agencés pour régler les seuils des différents pixels élémentaires des pixels composites dans des fenêtres d'énergie différentes selon ladite répartition, les moyens de traitement étant agencés pour effectuer un traitement spatial des sorties desdits pixels de même énergie de réglage.

Dans un mode de réalisation particulier, au moins certaines des différentes fenêtres d'énergie sont définies par un seuil bas et un seuil haut.

Egalement dans un mode de réalisation particulier, au moins certaines des différentes fenêtres d'énergie sont contiguës.

Dans un autre mode de réalisation particulier, le détecteur est un détecteur bidimensionnel.

Dans un mode de réalisation particulier, le détecteur est un détecteur à pixels hybrides.

On décrira maintenant, à titre d'exemple non limitatif, un mode de réalisation particulier de l'invention, en référence aux dessins schématiques annexés dans lesquels :

- la figure 1 est une illustration du fonctionnement d'un dispositif de l'art antérieur ;
- la figure 2 est une vue en coupe à très grande échelle illustrant le fonctionnement d'un détecteur à comptage de photons ;
- la figure 3 est un schéma électrique d'un pixel du détecteur de la figure 2 ;
- la figure 4 représente un dispositif selon l'invention ; et
- les figures 5 et 6 sont des vues en plan de deux détecteurs susceptibles d'être utilisés dans un dispositif selon l'invention.

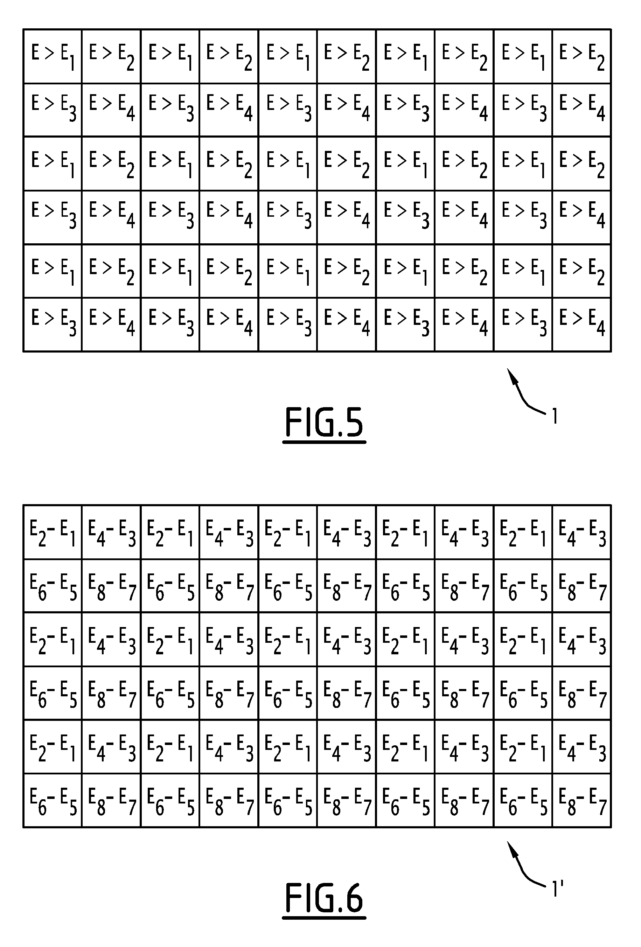

Si l'on se réfère à la figure 2, on voit qu'un détecteur à comptage de photons de type connu est composé de deux plaquettes 1 et 2 reliées par des points de soudure 3. La plaquette 1 est composée d'un substrat semi-conducteur (ou isolant pur) dans lequel les photons X se convertissent en charges électriques. On établit un champ électrique dans le substrat pour faire dériver ces charges vers les électrodes 4 en surface de la plaquette 1. Chaque électrode 4 correspond à un pixel du détecteur. On verra en référence aux figures 5 et 6 deux aménagements possibles pour les pixels.

Chaque électrode 4 est reliée électriquement par un point de soudure 3 à une électrode 5 de la plaquette 2 (un point de soudure par pixel). La plaquette 2 est une plaquette semi-conductrice comportant autant de chaînes d'analyse électronique complètes que de pixels. Chaque électrode 5 est donc une électrode d'entrée d'une chaîne d'analyse.

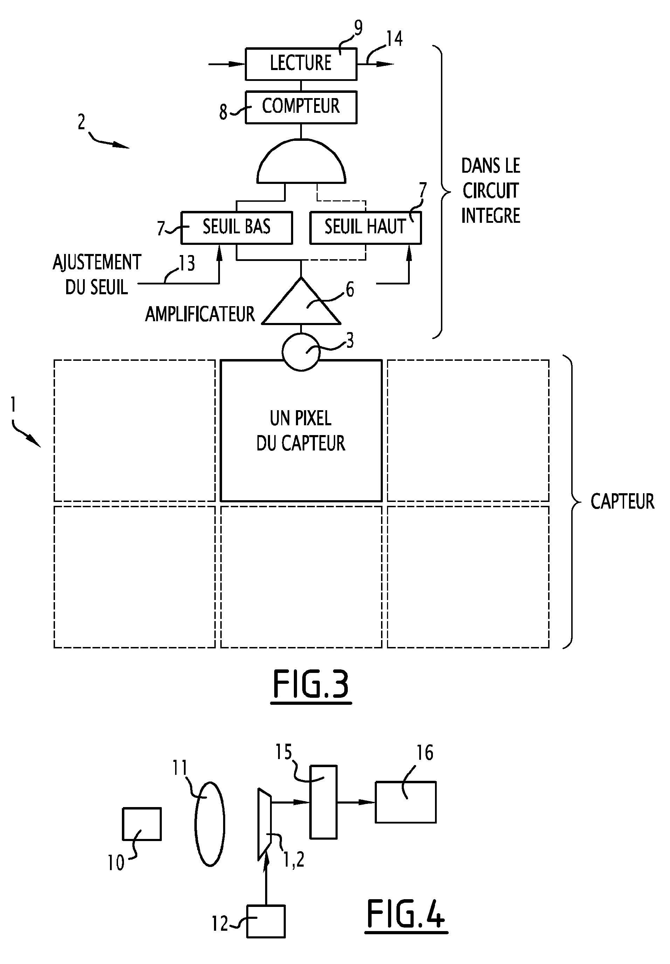

Si l'on se réfère à la figure 3, on voit que chaque chaîne d'analyse électronique est composée d'un amplificateur 6, d'une mise en forme, simple ou double seuil en énergie 7 et d'un compteur 8 qui est suivi d'un circuit de lecture 9.

Si l'on se réfère maintenant à la figure 4, on voit une source poly-chromatique 10 de rayons X et un détecteur 1, 2 tel que celui qui vient d'être décrit. Le sujet d'examen 11 est disposé entre la source et le détecteur.

Un dispositif 12 de réglage de seuils, par exemple un microordinateur, est relié aux connexions 13 d'ajustement de seuil de la plaquette 2.

Les sorties 14 de lecture de la plaquette 2 sont reliées à un processeur (par exemple du type FPGA) 15 dont la sortie est reliée à une unité de traitement 16, par exemple le même microordinateur que le dispositif 12.

Dans le détecteur pixellisé 1 à comptage de photons, chacun des pixels est associé à un circuit électronique tel que décrit ci-dessus permettant de compter les photons dont l'énergie est supérieure à une valeur donnée (seuil en énergie). Ce seuil est réglable par programmation à partir du microordinateur 12.

Le système de lecture 9 et le système de réglage du seuil 7 possèdent une vitesse d'exécution telle que l'on puisse faire se succéder de manière opérationnelle, cyclique ou non, les trois opérations : réglage du seuil - prise de données - lecture, pratiquement sans temps mort (par exemple de l'ordre de 2 microsecondes) par rapport au temps de prise de données. Ceci est obtenu par un système de transfert rapide dans des registres transitoires situés dans la plaquette 2, une matrice prédéfinie de valeurs de polarisations assignées au dispositif de réglage des seuils 13 et un programme d'exécution dans le processeur 15.

Dans le cas d'un réglage cyclique des seuils, on peut prendre l'exemple d'un tomographe à deux fenêtres en énergie. La séquence de prise de donnée est la suivante :

Image 1

- réglage du seuil 1 - prise de données - lecture - réglage du seuil2 - prise de données - lecture - réglage du seuil 3 - prise de données - lecture - réglage du seuil 4 - prise de données - lecture, etc....
- un pas de rotation des appareils autour du sujet 11, puis

Image 2

- réglage du seuil 1 - prise de données - lecture - réglage du seuil2 - prise de données - lecture - réglage du seuil 3 - prise de données - lecture - réglage du seuil 4 - prise de données - lecture, etc....
- un pas de rotation des appareils autour du sujet 11, puis

Image 3, etc.....

Ces opérations se font simultanément sur tous les pixels.

On obtient ainsi autant de fenêtre en énergie que l'on veut avec une électronique à simple seuil et en conservant la résolution spatiale maximum correspondant à la dimension d'un pixel, aussi bien en intensité qu'en fenêtre spectrale.

Dans un autre mode de mise en oeuvre, le réglage dynamique des seuils peut s'effectuer de façon adaptative sur la base d'un critère tel que la qualité du contraste de l'image. Ce critère peut être calculé au niveau de l'unité de traitement 16 qui adresse les nouveaux réglages à effectuer au dispositif de réglage 12.

On se réfère maintenant à la figure 5.

Le principe des pixels composites consiste à grouper un certain nombre de pixels (2, 3, 4 ou plus) et d'assigner un seuil différent à chacun des pixels élémentaires ou à chacun des sous-ensembles (connexe ou convexe) de pixels élémentaires de ce pixel composite. En une prise de vue, l'appareil est ainsi capable de compter les photons à partir de seuils différents. Par soustraction des comptages des pixels de seuils différents on obtient le nombre de photons correspondant à une fenêtre en énergie.

Par exemple, dans le cas de pixels composites de quatre pixels élémentaires, on peut obtenir, en une seule pose, deux fenêtres différentes :

Soit En le nombre de photons comptés pour une énergie supérieure à

$$E_n, \text{ et } E_1 < E_2 < E_3 < E_4$$

$$(E_2 - E_1) = [(E < E_2) - (E < E_1)]$$

et

$$(E_4 - E_3) = [(E < E_4) - (E < E_3)]$$

Pour sélectionner les éléments d'image qui correspondent à un corps qui présente un saut d'absorption à l'énergie $E_5$ telle que

$$E_2 < E_5 < E_3$$

On fait la différence des comptages correspondant à ces deux fenêtres :

$$(E_4 - E_3) - (E_2 - E_1).$$

Dans le cas où les deux fenêtres sont contiguës, les pixels composites peuvent être composés de seulement trois pixels élémentaires pour former deux fenêtres :

$$(E_2 - E_1) = [(E < E_2) - (E < E_1)]$$

et

$$(E_3 - E_2) = [(E < E_3) - (E < E_2)]$$

On peut les disposer en sous-groupes de la façon suivante :

$$E_1 \ E_2 \ E_3$$

$$E_3 \ E_1 \ E_2$$

ou

$$E_1 \ E_2 \ E_3$$

$$E_3 \ E_1 \ E_2$$

$$E_2 \ E_3 \ E_1$$

et moyenner les valeurs mesurées dans les pixels élémentaires réglés sur le même seuil.

Dans le mode de réalisation de la figure 6, on a directement, pour chacun des pixels, le nombre de photons correspondant à une fenêtre en énergie et deux pixels suffisent pour faire ressortir les éléments d'image correspondant à un corps qui présente un saut d'absorption à l'énergie $E_5$ telle que

$$E_2 < E_5 < E_3$$

Un pixel composite de quatre pixels permet de marquer des éléments d'images correspondant à deux corps (ou produits de contraste) différents, et ceci en une seule pose.

## Revendications

1. Dispositif d'imagerie par rayons X, comprenant une source poly-chromatique (10) de rayons X, et un détecteur (1, 2) à pixels adaptés à fonctionner en mode de comptage de photons dans au moins une fenêtre d'énergie délimitée par au moins un seuil réglable, au moins un compteur, de sorte que chaque pixel fournit une sortie fonction du nombre de photons reçus par ledit pixel dans lesdites fenêtres d'énergie pendant un intervalle de temps prédéterminé, des moyens de réglage (12) aptes à régler en temps réel les seuils desdits pixels successivement dans différentes fenêtres d'énergie et des moyens de traitement (16) pour effectuer en temps réel un traitement différentiel des sorties desdits pixels dans lesdites différentes fenêtres d'énergie **caractérisé en ce que**
les moyens de réglage sont agencés pour régler les seuils desdits pixels en temps réel à différentes valeurs selon une répartition temporelle cyclique; et les moyens de traitement sont agencés pour traiter selon un agencement temporel les sorties desdits pixels.

2. Dispositif selon la revendication 1, dans lequel lesdits pixels sont des pixels élémentaires groupés en pixels composites selon une répartition géométrique prédéterminée, et les moyens de réglage sont agencés pour régler les seuils des différents pixels élémentaires des pixels composites dans des fenêtres d'énergie différentes selon ladite répartition, les moyens de traitement étant agencés pour effectuer un traitement spatial des sorties desdits pixels de même énergie de réglage.

3. Dispositif selon l'une quelconque des revendications 1 à 2, dans lequel au moins certaines des différentes fenêtres d'énergie sont définies par un seuil bas et un seuil haut.

4. Dispositif selon l'une quelconque des revendications 1 à 3, dans lequel au moins certaines des différentes fenêtres d'énergie sont contiguës.

5. Dispositif selon l'une quelconque des revendications 1 à 4, dans lequel le détecteur est un détecteur bidimensionnel.

6. Dispositif selon l'une quelconque des revendications 1 à 5, dans lequel le détecteur est un détecteur à pixels hybrides.

## Patentansprüche

1. Röntgenbildgebungsvorrichtung, umfassend eine polychromatische Röntgenquelle (10) und einen Pixeldetektor (1, 2), der angepasst ist, im Modus des Zählens von Photonen in mindestens einem Energiefenster, das durch mindestens eine einstellbare Schwelle begrenzt ist, zu arbeiten, mindestens einen Zähler, derart, dass jeder Pixel ein Ausgangssignal abhängig von der Photonenanzahl liefert, die von dem Pixel in den Energiefenstern während eines vorbestimmten Zeitintervalls empfangen wird, Einstellmittel (12), die geeignet sind, die Schwellen der Pixel aufeinanderfolgend in unterschiedlichen Energiefenstern in Echtzeit einzustellen und Verarbeitungsmittel (16) zum Durchführen einer differentiellen Verarbeitung der Ausgangssignale der Pixel in den unterschiedlichen Energiefenstern in Echtzeit, **dadurch gekennzeichnet, dass**
die Einstellmittel ausgebildet sind, die Schwellen der Pixel in Echtzeit auf unterschiedliche Werte gemäß einer zyklischen zeitlichen Verteilung einzustellen, und
die Verarbeitungsmittel ausgebildet sind, die Ausgangssignale der Pixel gemäß einer zeitlichen Anordnung zu verarbeiten.

2. Vorrichtung nach Anspruch 1, bei der die Pixel Elementarpixel sind, die in Verbundpixel gemäß einer vorbestimmten geometrischen Verteilung gruppiert sind, und die Einstellmittel ausgebildet sind, die Schwellen der unterschiedlichen Elementarpixel der Verbundpixel in den unterschiedlichen Energiefenstern gemäß der Verteilung einzustellen, wobei die Verarbeitungsmittel ausgebildet sind, eine räumliche Verarbeitung der Ausgangssignale der Pixel gleicher Einstellenergie durchzuführen.

3. Vorrichtung nach einem beliebigen der Ansprüche 1 bis 2, bei der mindestens einige der unterschiedlichen Energiefenster durch eine niedrige Schwelle und eine hohe Schwelle definiert sind.

4. Vorrichtung nach einem beliebigen der Ansprüche 1 bis 3, bei der mindestens einige der unterschiedlichen Energiefenster aneinandergrenzen.

5. Vorrichtung nach einem beliebigen der Ansprüche 1 bis 4, bei der der Detektor ein zweidimensionaler Detektor ist.

6. Vorrichtung nach einem beliebigen der Ansprüche 1 bis 5, bei der der Detektor ein Hybrid-Pixeldetektor ist.

**Claims**

1. X-ray imaging device comprising a polychromatic X-ray source (10) and a detector (1, 2) having pixels adapted to operate in photon counting mode in at least one energy window delimited by at least one adjustable threshold, at least one counter, so that each pixel delivers an output dependent on the number of photons received by said pixel in said energy windows during a predetermined time interval, adjustment means (12) capable of adjusting, in real time, the thresholds of said pixels in succession in different energy windows, and processing means (16) for carrying out, in real time, differential processing of the outputs of said pixels in said different energy windows **characterized in that** the adjustment means are arranged to adjust the thresholds of said pixels, in real time, to different values according to a cyclic temporal distribution, and the processing means are arranged to process the outputs of said pixels according to a temporal arrangement.

2. Device according to claim 1, in which said pixels are elementary pixels grouped into composite pixels according to a predetermined geometric distribution, and the adjustment means are arranged to adjust the thresholds of the different elementary pixels of the composite pixels in different energy windows according to said distribution, the processing means being arranged to carry out spatial processing of the outputs of said pixels of the same adjustment energy.

3. Device according to any one of claims 1 to 2, in which at least some of the different energy windows are defined by a bottom threshold and a top threshold.

4. Device according to any one of claims 1 to 3, in which at least some of the different energy windows are contiguous.

5. Device according to any one of claims 1 to 4, in which the detector is a two-dimensional detector.

6. Device according to any one of claims 1 to 5, in which the detector is a hybrid pixel detector

FIG.1

FIG.2

FIG.3

FIG.4

| | | | | | | | | | |
|---|---|---|---|---|---|---|---|---|---|
| $E > E_1$ | $E > E_2$ | $E > E_1$ | $E > E_2$ | $E > E_1$ | $E > E_2$ | $E > E_1$ | $E > E_2$ | $E > E_1$ | $E > E_2$ |
| $E > E_3$ | $E > E_4$ | $E > E_3$ | $E > E_4$ | $E > E_3$ | $E > E_4$ | $E > E_3$ | $E > E_4$ | $E > E_3$ | $E > E_4$ |
| $E > E_1$ | $E > E_2$ | $E > E_1$ | $E > E_2$ | $E > E_1$ | $E > E_2$ | $E > E_1$ | $E > E_2$ | $E > E_1$ | $E > E_2$ |
| $E > E_3$ | $E > E_4$ | $E > E_3$ | $E > E_4$ | $E > E_3$ | $E > E_4$ | $E > E_3$ | $E > E_4$ | $E > E_3$ | $E > E_4$ |
| $E > E_1$ | $E > E_2$ | $E > E_1$ | $E > E_2$ | $E > E_1$ | $E > E_2$ | $E > E_1$ | $E > E_2$ | $E > E_1$ | $E > E_2$ |
| $E > E_3$ | $E > E_4$ | $E > E_3$ | $E > E_4$ | $E > E_3$ | $E > E_4$ | $E > E_3$ | $E > E_4$ | $E > E_3$ | $E > E_4$ |

## FIG.5

1

| | | | | | | | | | |
|---|---|---|---|---|---|---|---|---|---|
| $E_2 - E_1$ | $E_4 - E_3$ | $E_2 - E_1$ | $E_4 - E_3$ | $E_2 - E_1$ | $E_4 - E_3$ | $E_2 - E_1$ | $E_4 - E_3$ | $E_2 - E_1$ | $E_4 - E_3$ |
| $E_6 - E_5$ | $E_8 - E_7$ | $E_6 - E_5$ | $E_8 - E_7$ | $E_6 - E_5$ | $E_8 - E_7$ | $E_6 - E_5$ | $E_8 - E_7$ | $E_6 - E_5$ | $E_8 - E_7$ |
| $E_2 - E_1$ | $E_4 - E_3$ | $E_2 - E_1$ | $E_4 - E_3$ | $E_2 - E_1$ | $E_4 - E_3$ | $E_2 - E_1$ | $E_4 - E_3$ | $E_2 - E_1$ | $E_4 - E_3$ |
| $E_6 - E_5$ | $E_8 - E_7$ | $E_6 - E_5$ | $E_8 - E_7$ | $E_6 - E_5$ | $E_8 - E_7$ | $E_6 - E_5$ | $E_8 - E_7$ | $E_6 - E_5$ | $E_8 - E_7$ |
| $E_2 - E_1$ | $E_4 - E_3$ | $E_2 - E_1$ | $E_4 - E_3$ | $E_2 - E_1$ | $E_4 - E_3$ | $E_2 - E_1$ | $E_4 - E_3$ | $E_2 - E_1$ | $E_4 - E_3$ |
| $E_6 - E_5$ | $E_8 - E_7$ | $E_6 - E_5$ | $E_8 - E_7$ | $E_6 - E_5$ | $E_8 - E_7$ | $E_6 - E_5$ | $E_8 - E_7$ | $E_6 - E_5$ | $E_8 - E_7$ |

## FIG.6

1'

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 19904904
- US 20050123093 A
- US 20060056581 A
- US 6922462 B
- GB 2318411 A
- US 3376420 A

**Littérature non-brevet citée dans la description**

- **P. DELPIERRE et al.** XPAD: A photons counting pixel detector for material sciences and small animal imaging. *Nucl. Instr. Meth. in Physics Research A,* 2007, vol. 572, 250-253
- **P. PANGAUD et al.** XPAD3: A new photon counting chip for X-ray CT-scanner. *Nucl. Instr. Meth. in Physics Research A,* 2007, vol. 571, 321-324
- **P. DELPIERRE et al.** PIXSCAN: Pixel detector CT-scanner for small animal imaging. *Nucl. Instr. Meth. in Physics Research A,* 2007, vol. 571, 425-428
- An area efficient readout architecture for photon counting color imaging. **LUNGREN et al.** Nuclear Instruments and Methods in Physics Research, Section A, Accelerators, spectrometers, detectors. Elsevier, 06 Février 2007, vol. 576, 132-136